(19) Europäisches Patentamt
European Patent Office
Office européen des brevets

(11) EP 4 641 235 A1

(12) EUROPEAN PATENT APPLICATION
published in accordance with Art. 153(4) EPC

(43) Date of publication:
29.10.2025  Bulletin 2025/44

(21) Application number: 23932676.2

(22) Date of filing: 03.08.2023

(51) International Patent Classification (IPC):
G01R 31/396 (2019.01)    G06F 11/07 (2006.01)

(52) Cooperative Patent Classification (CPC):
Y02E 60/10

(86) International application number:
PCT/CN2023/110911

(87) International publication number:
WO 2024/212403 (17.10.2024 Gazette 2024/42)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 13.04.2023  CN 202310392919

(71) Applicant: Hefei Gotion High-Tech Power Energy
Co., Ltd.
Hefei, Anhui 230012 (CN)

(72) Inventors:
• ZHANG, Wen
  Hefei, Anhui 230012 (CN)

• JIANG, Song
  Hefei, Anhui 230012 (CN)
• MAO, Xiaohai
  Hefei, Anhui 230012 (CN)
• GAO, Fei
  Hefei, Anhui 230012 (CN)
• LUO, Dazhi
  Hefei, Anhui 230012 (CN)
• ZHANG, Bing
  Hefei, Anhui 230012 (CN)

(74) Representative: Winter, Brandl - Partnerschaft
mbB
Alois-Steinecker-Straße 22
85354 Freising (DE)

(54) **LITHIUM BATTERY DATA ACQUISITION ANOMALY IDENTIFICATION METHOD AND SYSTEM, STORAGE MEDIUM AND DEVICE**

(57)    The present invention relates to a lithium battery data acquisition anomaly identification method and system, a storage medium and a device. The method includes: performing data preprocessing on voltage data of a battery management system to form derived voltage time series features; extracting voltage time series features of adjacent cells in a battery pack according to the derived voltage time series features, and calculating the mean and variance of voltages of all cells, to form new voltage time series features; performing anomaly identification on the new voltage time series features to find out an outlying time series point of a cell voltage; and performing time series analysis on voltages of adjacent cells according to the outlying time series point of a cell voltage, and identifying a position where voltage acquisition of adjacent cells is anomalous. According to the present invention, the accuracy of anomaly identification of voltage acquisition of adjacent cells can be improved, and the method can be applied to the fields of lithium-ion battery state acquisition, monitoring and early warning.

Perform data preprocessing on voltage data of a battery management system to form derived voltage time series features

Extract voltage time series features of adjacent cells in a battery pack according to the derived voltage time series features, and calculate the mean and variance of voltages of all cells, to form new voltage time series features

Perform anomaly identification on the new voltage time series features to find out an outlying time series point of a cell voltage

Perform time series analysis on voltages of adjacent cells according to the outlying time series point of a cell voltage, and identify a position where voltage acquisition of adjacent cells is anomalous

Fig. 1

## Description

## Technical Field

The present invention relates to the fields of lithium-ion battery state acquisition, monitoring and early warning, in particular to a lithium battery data acquisition anomaly identification method and system, a storage medium and a device based on time series analysis and anomaly detection..

## Background Art

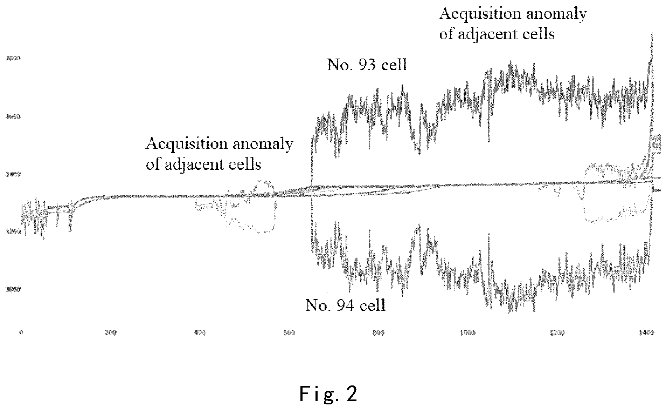

In a process of using an electric vehicle, it is necessary to acquire, monitor and early warn state parameters (such as a voltage, a current and a temperature) of a battery pack in real time to ensure the normal use of the battery pack. However, due to a manufacturing process, poor acquisition line contact, battery pack faults and other reasons, there will be a situation that voltage acquisition of adjacent cells is anomalous, which is usually embodied as that a voltage of one cell is increased, a voltage of the other cell is reduced, and there is certain symmetry; and a mean of the two cells and a mean of all cells have the same variation trend, as shown in Fig. 2. Thus, a management strategy of a battery management system and a monitoring algorithm strategy of a cloud will be affected, and problems such as false alarm of a fault and fault detection failure will occur.

The battery management system (BMS) gives operation strategies under different working conditions by detecting and monitoring voltages of cells in real time to ensure the safety use of a battery. If voltage acquisition of adjacent cells is anomalous, on one hand, the operation strategies of the BMS will be affected, and on the other hand, the BMS will ignore faults that have occurred in the battery, thereby resulting in potential safety hazards.

In existing algorithm strategies, a situation that voltage acquisition of adjacent cells is anomalous is not considered, and accurate determination for an anomaly of voltage acquisition of adjacent cells by time series analysis is not performed either; and voltage jump caused by other fault types will also affect the anomaly identification of voltage acquisition of adjacent cells. For the anomaly identification of voltage acquisition of adjacent cells, a trend within a period of time needs to be determined, and the BMS has storage defects, and therefore, the anomaly is usually identified on the cloud. In addition, it is difficult to identify the acquisition anomaly in various cases by single rule and anomaly detection.

## Summary of the Invention

For solving the above-mentioned problems, the object of the present invention is to provide a lithium battery data acquisition anomaly identification method and system, a storage medium and a device, which can improve the accuracy of anomaly identification of voltage acquisition of adjacent cells.

In order to achieve the above-mentioned object, the present invention adopts the following technical solutions: a lithium battery data acquisition anomaly identification method, including: performing data preprocessing on voltage data of a battery management system to form derived voltage time series features; extracting voltage time series features of adjacent cells in a battery pack according to the derived voltage time series features, and calculating the mean and variance of voltages of all cells, to form new voltage time series features; performing anomaly identification on the new voltage time series features to find out an outlying time series point of a cell voltage; and performing time series analysis on voltages of adjacent cells according to the outlying time series point of a cell voltage, and identifying the position where voltage acquisition of adjacent cells is anomalous.

Further, the forming derived voltage time series features includes:

in the voltage data of the battery management system, dividing voltage, current and temperature information of a cell with two data point interval time exceeding a preset time into two different series fragments;
in each series fragment, performing missing value filling on series fragments of which the voltage data is 0, and removing noise points with voltages exceeding a preset range; and
processing voltage data of all the cells, and then organizing into a time series to form the derived voltage time series features.

Further, the forming new voltage time series features includes:

extracting voltages of all adjacent cells according to the derived voltage time series feature data; and
calculating the mean and variance of the voltages of all the cells in the battery pack, and then organizing with the voltages of all adjacent cells into the new voltage time-series features.

Further, the finding out an outlying time series point of a cell voltage includes: finding out an outlying cell by using an N-sigma method according to a voltage time series, and determining whether time series of the adjacent cells are outlying time series, to obtain the outlying time series point of a cell voltage.

Further, the determining whether time series of the adjacent cells are outlying time series includes: if a voltage of a cell i at time t satisfies a preset condition, determining that the voltage is not an outlier, and marking an outlier flag bit as 0;

if the voltage of the cell i at the time t does not satisfy the preset condition, determining that the voltage is a voltage outlier, and marking the outlier flag bit as 1; and

determining the voltages of all adjacent cells to obtain the time series [0 1 1 ⋯ 0] determining whether the voltages of adjacent cells are the outliers.

Further, the preset condition is expressed as:

$$(\overline{U}_t - N * \delta_t) < U_t^i < (N * \delta_t + \overline{U}_t)$$

wherein $U_t^i$ represents the voltage of the cell i at the time t, $\overline{U}_t$ is the mean of the voltages of the cells, $\delta_t$ is the variance of the voltages of the cells, and N is an N value of the N-sigma method.

Further, the performing time series analysis on voltages of adjacent cells includes:

smoothing and denoising an outlier flag bit series by using a sliding window;
performing series analysis on the time series of the voltages of adjacent cells according to the outlier flag bit series, calculating a difference value of the voltages of adjacent cells, and determining and identifying voltage rise and drop trends according to a difference and a threshold; calculating a difference of a mean of a voltage of the entire battery pack to determine a variation trend of the voltage of the entire battery pack, and calculating a difference of a mean of the voltages of adjacent cells to determine variation trends of the voltages of adjacent cells; and
if the variation trends of the voltages of two adjacent cells are opposite and the variation trends of the voltages of adjacent cells are the same as the variation trend of the entire battery pack, regarding that voltage acquisition of adjacent cells is anomalous, and calculating a starting point and an end position of an anomaly at the same time.

Provided is a lithium battery data acquisition anomaly identification system, including: a first processing module configured to perform data preprocessing on voltage data of a battery management system to form derived voltage time series features; a second processing module configured to extract voltage time series features of adjacent cells in a battery pack according to the derived voltage time series features, and calculate the mean and variance of voltages of all cells, to form new voltage time series features; a third processing module configured to perform anomaly identification on the new voltage time series features to find out an outlying time series point of a cell voltage; and an identification module configured to perform time series analysis on voltages of adjacent cells according to the outlying time series point of a cell voltage, and identify the position where voltage acquisition of adjacent cells is anomalous.

Provided is a computer-readable storage medium having one or more programs stored thereon, wherein the one or more programs include instructions, and the instructions, when executed by a computing device, enable the computing device to perform any one method in the above-mentioned methods.

Provided is a computing device, including one or more processors, a memory and one or more programs, wherein the one or more programs are stored in the memory and are configured to be executed by the one or more processors, and the one or more programs include instructions for performing any one method in the above-mentioned methods.

Due to the adoption of the above-mentioned technical solutions, the present invention has the following advantages:

according to the present invention, the situation that voltage acquisition of adjacent cells is anomalous in various cases can be identified, a certain anti-interference ability for noise and anomalous points is achieved, and the improved time series analysis has higher accuracy, so that the anomaly of voltage acquisition of adjacent cells can be accurately identified, the accuracy rate of an early warning system can be increased, the fault rate generated during battery operation can be reduced, and the user experience can be improved.

## Brief Description of the Drawings

Fig. 1 is a flow diagram of a lithium battery data acquisition anomaly identification method in an embodiment of the present invention;
Fig. 2 is a schematic diagram of an anomaly of voltage acquisition of adjacent cells in an embodiment of the present invention;
Fig. 3 is a schematic diagram of smoothing performed by using a sliding window in an embodiment of the present invention; and
Fig. 4 is a schematic diagram of denoising performed by using a sliding window in an embodiment of the present invention.

## Detailed Description of the Invention

In order to make objects, technical solutions and advantages of the embodiments of the present invention clearer, the technical solutions in the embodiments of the present invention will be described clearly and completely below in conjunction with accompanying drawings in the embodiments of the present invention. Obviously, the described embodiments are a part of the embodiments of the present invention, not all the embodiments. Based on the described embodiments of the present invention, all other embodiments obtained by those of ordinary skill in the art without creative work shall fall within the protective scope of the present invention.

It should be noted that terms used herein are only intended to describe specific implementations, rather than to limit exemplary implementations according to the present invention. As used herein, a singular form is also intended to include a plural form unless it is explicitly indicated in the context otherwise. In addition, it should be further understood that when terms "include" and/or "comprise" are used in this description, it is indicated that there are features, steps, operations, devices, components and/or combinations thereof.

In order to solve the problem how to improve the accuracy of anomaly identification of voltage acquisition of adjacent cells, the present invention provides a lithium battery data acquisition anomaly identification method and system, a storage medium and a device. For an anomaly of voltage acquisition of adjacent cells, an identification result is optimized by using a time series analysis and anomaly detection fused method and improving a series analysis strategy. The present invention includes: voltage data of a battery management system (BMS) is uploaded to a big data cloud platform in real time, and data preprocessing is performed to derive time series features of voltages; voltage time series features of adjacent cells in a battery pack are extracted, and data features such as the mean and variance of voltages of all cells are calculated; an outlying time series point of a cell voltage is found out by using an N-sigma anomaly identification method; and time series analysis is performed on voltages of adjacent cells, and the position where voltage acquisition of adjacent cells is anomalous is identified in conjunction with analysis for the outlying time series point. According to the present invention, the situation that voltage data acquisition of adjacent cells in the battery pack is anomalous can be found out, which is beneficial to rapid positioning of a fault problem and the assistance in fault maintenance, and is also beneficial to the improvement of the accuracy of algorithms such as risk early earning and battery health state evaluation for cloud and vehicle systems. Moreover, the present invention can effectively identify the problem that data acquisition is anomalous, and can assist in battery fault early warning, reduce safety risks and improve user experience.

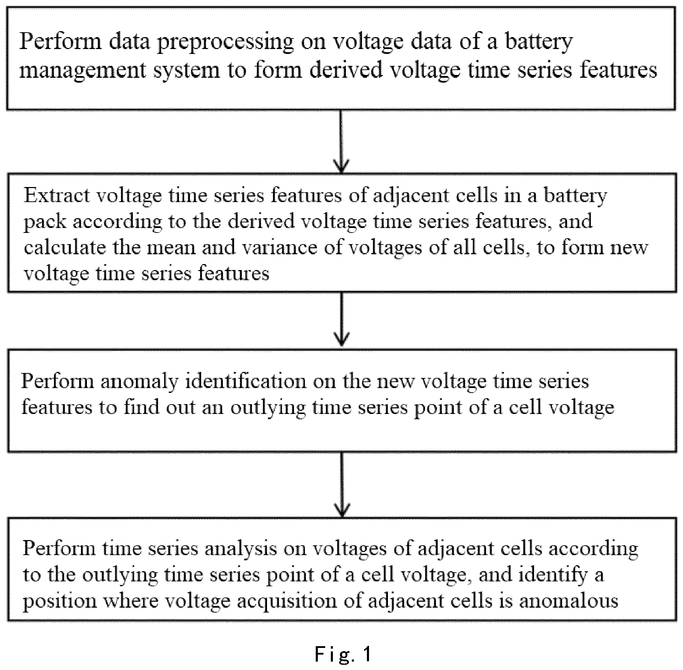

In an embodiment of the present invention, provided is a lithium battery data acquisition anomaly identification method, i.e., an adjacent cell battery data acquisition anomaly identification method. In the present embodiment, as shown in Fig. 1, the method includes the following steps:

1) Data preprocessing is performed on voltage data of a BMS to form derived voltage time series features;
2) Voltage time series features of adjacent cells in a battery pack are extracted according to the derived voltage time series features, and the mean and variance of voltages of all cells are calculated to form new voltage time series features;
3) Anomaly identification is performed on the new voltage time series features to find out an outlying time series point of a cell voltage; and
4) Time series analysis is performed on voltages of adjacent cells according to the outlying time series point of a cell voltage, and position where voltage acquisition of adjacent cells is anomalous is identified.

In the present embodiment, the voltage data of the battery management system in step 1) can be uploaded in real time to a big data cloud platform for processing. The big data cloud platform refers to a cloud platform constructed by using a big data technology and used for processing and storing state information of a power battery.

In the above-mentioned step 1), the step that derived voltage time series features are formed includes the following steps:

1.1) in the voltage data of the battery management system, voltage, current, temperature or other information of a cell with two data point interval time exceeding a preset time is divided into two different series fragments;
Optionally, the interval time is 10-30 seconds; and a voltage, a current, a temperature or other information of a cell of the battery pack is collected and processed;
Optionally, the preset time is preferably 300 seconds.
1.2) in each series fragment, missing value filling is performed on series fragments of which the voltage data is 0, and noise points with voltages exceeding a preset range are removed;
Optionally, missing value filling is performed by interpolation method on a small number of series fragments of which the voltage data is 0; and
1.3) voltage data of all the cells is processed and then organized into a time series to form the derived voltage time series features.

In the above-mentioned step 2), the step that new voltage time series features are formed includes the following steps:

2.1) voltages of all adjacent cells are extracted according to derived voltage time series feature data;
Wherein for a battery pack with M cells, M-1 pairs of adjacent cells need to be extracted; and
2.2) data features such as the mean $\overline{U}_t$ and variance $\delta_t$ of the voltages of all the cells in the battery pack are calculated, and are organized with the voltages of all adjacent cells (i.e., voltages of the M-1 pairs of adjacent cells) into the new voltage time series features.

In the above-mentioned steps 3), the step that an outlying time series point of a cell voltage is found out specifically includes: find out an outlying cell by using an N-sigma method according to a voltage time series, and determine whether time series of the adjacent cells are outlying time series, to obtain the outlying time series point of a cell voltage.

The step of determining whether time series of the adjacent cells are outlying time series includes the following steps:

3.1) if a voltage $U_t^i$ of a cell i at time t satisfies a preset condition, it is determined that the voltage $U_t^i$ is not an outlier, and an outlier flag bit is marked as 0;

3.2) if the voltage $U_t^i$ of the cell i at the time t does not satisfy the preset condition, it is determined that the voltage is a voltage outlier, and the outlier flag bit is marked as 1; and 3.3) the voltages of all adjacent cells are determined to obtain the time series [0 1 1 ··· 0] determining whether the voltages of adjacent cells are the outliers.

In the present embodiment, the preset condition is expressed as:

$$(\overline{U}_t - N * \delta_t) < U_t^i < (N * \delta_t + \overline{U}_t)$$

wherein $U_t^i$ represents the voltage of the cell i at the time t, $\overline{U}_t$ is the mean of the voltages of the cells, $\delta_t$ is the variance of the voltages of the cells, and N is an N value of the N-sigma method. In the above-mentioned step 4), the step that time series analysis is performed on voltages of adjacent cells includes the following steps:

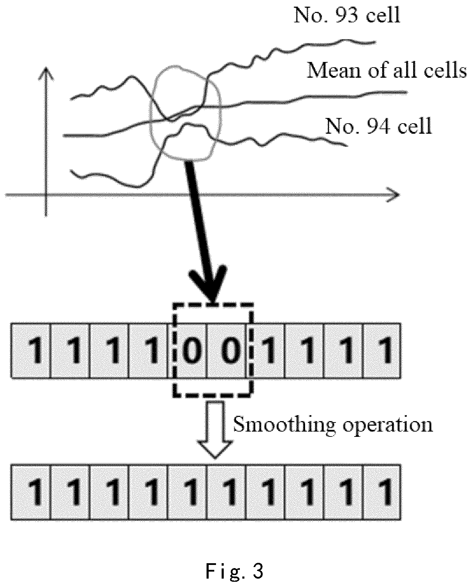

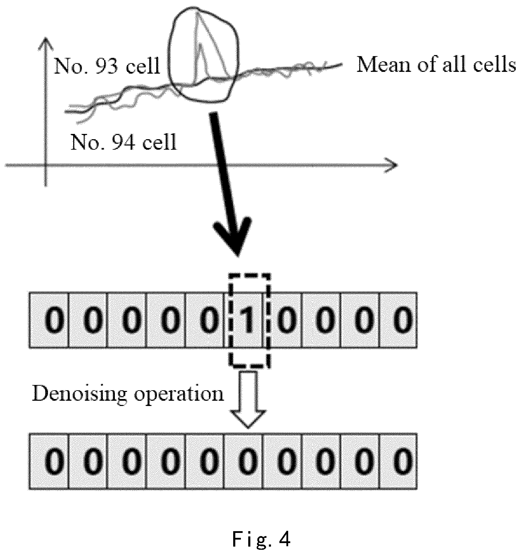

4.1) an outlier flag bit series is smoothed and denoised by using a sliding window;
as shown in Fig. 3 and Fig. 4, less than three flags 0 are included among continuous flags 1, 0 is modified as 1, and an outlier point is smoothed; and if less than three flags 1 are included among continuous flags 0, 1 is modified as 0, and a small number of anomalous points are denoised. Smoothing and denoising are performed by using the sliding window and series counting.
4.2) series analysis is performed on the time series of the voltages of adjacent cells according to the outlier flag bit series, a difference value of the voltages of adjacent cells is calculated, and voltage rise and drop trends are determined and identified according to a difference and a threshold;
in the present embodiment, if the difference value is a continuous positive value, the voltages are in the rise trend, and if the difference value is a continuous negative value, the voltages are in the drop trend.

4.3) a difference of a mean of a voltage of the entire battery pack is calculated to determine a variation trend of the voltage of the entire battery pack, and a difference of a mean of the voltages of adjacent cells is calculated to determine variation trends of the voltages of adjacent cells;
Wherein the variation trend of the voltage of the entire battery pack is determined: the continuous positive value represents the rise trend, and the continuous negative value represents the drop trend.

The variation trends of the voltages of the adjacent cells are determined: the continuous positive value represents the rise trend, and the continuous negative value represents the drop trend.
4.4) if the variation trends of the voltages of two adjacent cells are opposite and the variation trends of the voltages of adjacent cells are the same as the variation trend of the entire battery pack, it is regarded that voltage acquisition of adjacent cells is anomalous, and a starting point and an end position of an anomaly are calculated at the same time so that determination for the anomaly of voltage acquisition of adjacent cells and identification for the position are achieved.
In conclusion, according to the present invention, vehicle maintenance and battery fault problem identification can be achieved in a process of maintaining an entire vehicle, so that the situation of reporting faults on the market is reduced, and the brand competitiveness and user experience are improved. In the present invention, various situations that voltage acquisition of adjacent cells is anomalous are comprehensively considered, and a plurality of dimensions such as variation trend analysis, outlier point smoothing and denoising and anomaly detection are fused, so that the anomaly of voltage acquisition of adjacent cells is identified rapidly and effectively. By means of the smoothing and denoising of the time series, the accuracy of identification can be effectively increased, the accuracy rate of early warning can be increased, the fault rate and the operation cost can be reduced, the user experience can be improved, and the safety of life or property of a user can be protected.
In an embodiment of the present invention, provided is a lithium battery data acquisition anomaly identification system, including:

a first processing module configured to perform data preprocessing on voltage data of a battery management system to form derived voltage time series features;
a second processing module configured to extract voltage time series features of adjacent cells in a battery pack according to the derived voltage time series features, and calculate the mean and variance of voltages of all cells, to form new voltage time series features;

a third processing module configured to perform anomaly identification on the new voltage time series features to find out an outlying time series point of a cell voltage; and

an identification module configured to perform time series analysis on voltages of adjacent cells according to the outlying time series point of a cell voltage, and identify the position where voltage acquisition of adjacent cells is anomalous.

In the above-mentioned embodiment, the step that derived voltage time series features are formed includes:

in the voltage data of the battery management system, voltage, current and temperature information of a cell with two data point interval time exceeding a preset time is divided into two different series fragments;

in each series fragment, missing value filling is performed on series fragments of which the voltage data is 0, and noise points with voltages exceeding a preset range are removed; and

voltage data of all the cells is processed and then organized into a time series to form the derived voltage time series features.

In the above-mentioned embodiment, the step that new voltage time series features are formed includes:

voltages of all adjacent cells are extracted according to derived voltage time series feature data; and

the mean and variance of the voltages of all the cells in the battery pack are calculated, and are organized with the voltages of all adjacent cells into the new voltage time series features.

In the above-mentioned embodiment, the step that an outlying time series point of a cell voltage is found out includes: finding out an outlying cell by using an N-sigma method according to a voltage time series, and determining whether time series of the adjacent cells are outlying time series, to obtain the outlying time series point of a cell voltage.

The step of determining whether time series of the adjacent cells are outlying time series includes:

if a voltage of a cell i at time t satisfies a preset condition, it is determined that the voltage is not an outlier, and an outlier flag bit is marked as 0;

if the voltage of the cell i at the time t does not satisfy the preset condition, it is determined that the voltage is a voltage outlier, and the outlier flag bit is marked as 1; and

the voltages of all adjacent cells are determined to obtain the time series [0 1 1 ⋯ 0] determining whether the voltages of adjacent cells are the outliers.

In the present embodiment, the preset condition is expressed as:

$$(\overline{U}_t - N * \delta_t) < U_t^i < (N * \delta_t + \overline{U}_t)$$

wherein $U_t^i$ represents the voltage of the cell i at the time t, $\overline{U}_t$ is the mean of the voltages of the cells, $\delta_t$ is the variance of the voltages of the cells, and N is an N value of the N-sigma method.

In the above-mentioned embodiment, the step that time series analysis is performed on voltages of adjacent cells includes:

an outlier flag bit series is smoothed and denoised by using a sliding window;

series analysis is performed on the time series of the voltages of adjacent cells according to the outlier flag bit series, a difference value of the voltages of adjacent cells is calculated, and voltage rise and drop trends are determined and identified according to a difference and a threshold;

a difference of a mean of a voltage of the entire battery pack is calculated to determine a variation trend of the voltage of the entire battery pack, and a difference of a mean of the voltages of adjacent cells is calculated to determine variation trends of the voltages of adjacent cells; and

if the variation trends of the voltages of two adjacent cells are opposite and the variation trends of the voltages of adjacent cells are the same as the variation trend of the entire battery pack, it is regarded that voltage acquisition of adjacent cells is anomalous, and a starting point and an end position of an anomaly is calculated at the same time.

The system provided in the present embodiment is used for performing each of the above-mentioned method embodiments, and specific flows and detailed contents thereof refer to the above-mentioned embodiments so as to be no longer repeated herein.

An embodiment of the present invention provides a computing device, and the computing device may be a terminal which may include a processor, a communication interface, a memory, a display screen and an input apparatus. Communication among the processor, the communication interface and the memory is completed by a communication bus. The processor is used for providing computation and control abilities. The memory includes a nonvolatile storage medium and an internal memory, the nonvolatile storage medium stores an operating system and a computer program, and the computer program, when executed by the processor, implements a lithium battery data acquisition anomaly identification method; and the internal memory provides an environment for the operation of the operating system and the computer program in the nonvolatile storage medium. The communication interface is used for performing communication with an external terminal in a wired or wireless way, and the wireless way can be achieved by WIFI, an administrator network, NFC (Near-field Communication) or other technologies. The display screen can be a liquid crystal display screen or an electronic ink display screen, and the input apparatus may be a touch layer covering the display screen, or a key, a trackball or a touch panel disposed on a housing of the computing device, or an external keyboard, touch panel or mouse, etc. the processor can call logic instructions in the memory.

In addition, the logic instructions in the above-mentioned memory can be implemented in a form of a software functional unit, and can be stored in a computer-readable storage medium when sold or used as an independent product. Based on such understanding, the essences of the technical solutions of the present invention or parts thereof making contributions to the prior art or parts of the technical solutions may be embodied in a form of a software product, and the computer software product is stored in a storage medium and includes a plurality of instructions used to enable a computer device (which may be a personal computer, a server, or a network device, etc.) to perform all or parts of steps of the method in each of the embodiments of the present invention. The aforementioned storage medium includes various media capable of storing program codes, such as a U disk, a mobile hard disk, an ROM (Read-Only Memory), an RAM (Random Access Memory), a diskette, and an optical disk.

In an embodiment of the present invention, provided is a computer program product. The computer program product, the computer program product includes a computer program stored on a non-transient computer-readable storage medium, the computer program includes a program instruction, and when the program instruction is executed by a computer, the computer can perform the method provided in each of the above-mentioned method embodiments.

In an embodiment of the present invention, provided is a non-transient computer-readable storage medium, the non-transient computer-readable storage medium stores a server instruction, and the computer instruction enables a computer to perform the method in each of the above-mentioned embodiments.

An implementation principle and technical effect of the computer-readable storage medium provided in the above-mentioned embodiment are similar to those of the above-mentioned method embodiments so as to be no longer repeated herein.

The present invention is described by referring to flow diagrams and/or block diagrams of the method, device (system) and computer program product according to the embodiments of the present invention. It should be understood that each flow and/or block in the flow diagrams and/or block diagrams as well as a combination of flows and/or blocks in the flow diagrams and/or block diagrams may be achieved by computer program instructions. The computer program instructions may be provided to a general-purpose computer, a special-purpose computer, an embedded processor or processors of other programmable data processing devices to generate a machine, so that an apparatus for achieving functions specified in one or more flows in the flow programs and/or one or more blocks in the block diagrams is generated through the instructions executed by the computer or the processors of other programmable data processing devices.

These computer program instructions may also be stored in a computer-readable memory capable of guiding the computer or other programmable data processing devices to work in a specific way, so that the instructions stored in the computer-readable memory generate a product including an instruction apparatus, and the instruction apparatus achieves the functions specified in the one or more flows in the flow diagrams and/or one or more blocks in the block diagrams.

These computer program instructions may also be loaded in the computer or other programmable data processing devices, so that a series of operation steps are performed on the computer or other programmable data processing devices to generate processing achieved by the computer, and furthermore, the instructions executed on the computer or other programmable data processing devices provide steps for achieving the functions specified in the one or more flows in the flow diagrams and/or one or more blocks in the block diagrams.

Finally, it should be noted that the above-mentioned embodiments are only intended to describe the technical solutions of the present invention, rather than to limit the technical solutions of the present invention. Although the present invention has been described in detail by referring to the aforementioned embodiments, it should be understood by those of ordinary skill in the art that they may still modify the technical solutions recorded in each of the aforementioned embodiments or equivalently substitute parts of technical features therein. These modifications or substitutions do not make the essences of the corresponding technical solutions depart from the spirit and scope of the technical solution of each of the embodiments of the present invention.

**Claims**

1. A lithium battery data acquisition anomaly identification method, wherein it comprises:

performing data preprocessing on voltage data of a battery management system to form derived voltage time series features;
extracting voltage time series features of adjacent cells in a battery pack according to the derived voltage time series features, and calculating the mean and variance of voltages of all cells, to form new voltage time series features; performing anomaly identification on the new voltage time series features to find out an outlying time series point of a cell voltage; and performing time series analysis on voltages of adjacent cells according to the outlying time series point of a cell voltage, and identifying a position where voltage acquisition of adjacent cells is anomalous.

2. The lithium battery data acquisition anomaly identification method of claim 1, wherein the forming derived voltage time series features comprises:

in the voltage data of the battery management system, dividing voltage, current and temperature information of a cell with two data point interval time exceeding a preset time into two different series fragments; in each series fragment, performing missing value filling on series fragments of which the voltage data is 0, and removing noise points with voltages exceeding a preset range; and processing voltage data of all the cells, and then organizing into a time series to form the derived voltage time series features.

3. The lithium battery data acquisition anomaly identification method of claim 1, wherein the forming new voltage time series features comprises:

extracting voltages of all adjacent cells according to the derived voltage time series feature data; and calculating the mean and variance of the voltages of all the cells in the battery pack, and then organizing with the voltages of all adjacent cells into the new voltage time-series features.

4. The lithium battery data acquisition anomaly identification method of claim 1, wherein the finding out an outlying time series point of a cell voltage comprises: finding out an outlying cell by using an N-sigma method according to a voltage time series, and determining whether time series of the adjacent cells are outlying time series, to obtain the outlying time series point of a cell voltage.

5. The lithium battery data acquisition anomaly identification method of claim 4, wherein the determining whether time series of the adjacent cells are outlying time series comprises:

if a voltage of a cell i at time t satisfies a preset condition, determining that the voltage is not an outlier, and marking an outlier flag bit as 0;

if the voltage of the cell i at the time t does not satisfy the preset condition, determining that the voltage is a voltage outlier, and marking the outlier flag bit as 1; and determining the voltages of all adjacent cells to obtain the time series [0 1 1 ⋯ 0] determining whether the voltages of adjacent cells are the outliers.

6. The lithium battery data acquisition anomaly identification method of claim 5, wherein the preset condition is expressed as:

$$(\overline{U}_t - N * \delta_t) < U_t^i < (N * \delta_t + \overline{U}_t)$$

wherein $U_t^i$ represents the voltage of the cell i at the time t, $\overline{U}_t$ is the mean of the voltages of the cells, $\delta_t$ is the variance of the voltages of the cells, and N is an N value of the N-sigma method.

7. The lithium battery data acquisition anomaly identification method of claim 1, wherein the performing time series analysis on voltages of adjacent cells comprises:

smoothing and denoising an outlier flag bit series by using a sliding window; performing series analysis on the time series of the voltages of adjacent cells according to the outlier flag bit series, calculating a difference value of the voltages of adjacent cells, and determining and identifying voltage rise and drop trends according to a difference and a threshold; calculating a difference of a mean of a voltage of the entire battery pack to determine a variation trend of the voltage of the entire battery pack, and calculating a difference of a mean of the voltages of adjacent cells to determine variation trends of the voltages of adjacent cells; and if the variation trends of the voltages of two adjacent cells are opposite and the variation trends of the voltages of adjacent cells are the same as the variation trend of the entire battery pack, regarding that voltage acquisition of adjacent cells is anomalous, and calculating a starting point and an end position of an anomaly at the same time.

8. A lithium battery data acquisition anomaly identification system, comprising:

a first processing module configured to perform data preprocessing on voltage data of a battery management system to form derived voltage time series features; a second processing module configured to extract voltage time series features of adjacent cells in a battery pack according to the derived voltage time series features, and calculate the mean and variance of voltages of all cells, to form new voltage time series features;

a third processing module configured to perform anomaly identification on the new voltage time series features to find out an outlying time series point of a cell voltage; and

an identification module configured to perform time series analysis on voltages of adjacent cells according to the outlying time series point of a cell voltage, and identify the position where voltage acquisition of adjacent cells is anomalous.

9. A computer-readable storage medium having one or more programs stored thereon, wherein the one or more programs comprise instructions, and the instructions, when executed by a computing device, enable the computing device to perform the method of any one of claims 1 to 7.

10. A computing device, comprising one or more processors, a memory and one or more programs, wherein the one or more programs are stored in the memory and are configured to be executed by the one or more processors, and the one or more programs comprise instructions for performing the method of any one of claims 1 to 7.

Perform data preprocessing on voltage data of a battery management system to form derived voltage time series features

Extract voltage time series features of adjacent cells in a battery pack according to the derived voltage time series features, and calculate the mean and variance of voltages of all cells, to form new voltage time series features

Perform anomaly identification on the new voltage time series features to find out an outlying time series point of a cell voltage

Perform time series analysis on voltages of adjacent cells according to the outlying time series point of a cell voltage, and identify a position where voltage acquisition of adjacent cells is anomalous

F i g. 1

Fig. 2

No. 93 cell

Mean of all cells

No. 94 cell

| 1 | 1 | 1 | 1 | 0 | 0 | 1 | 1 | 1 | 1 |

Smoothing operation

| 1 | 1 | 1 | 1 | 1 | 1 | 1 | 1 | 1 | 1 |

Fig. 3

No. 93 cell

No. 94 cell

Mean of all cells

| 0 | 0 | 0 | 0 | 0 | 1 | 0 | 0 | 0 | 0 |

Denoising operation

| 0 | 0 | 0 | 0 | 0 | 0 | 0 | 0 | 0 | 0 |

Fig. 4

## INTERNATIONAL SEARCH REPORT

| International application No. |
|---|
| **PCT/CN2023/110911** |

**A.    CLASSIFICATION OF SUBJECT MATTER**

G01R31/396(2019.01)i;  G06F11/07(2006.01)i

According to International Patent Classification (IPC) or to both national classification and IPC

**B.    FIELDS SEARCHED**

Minimum documentation searched (classification system followed by classification symbols)

IPC:G01R31 G06F11

Documentation searched other than minimum documentation to the extent that such documents are included in the fields searched

Electronic data base consulted during the international search (name of data base and, where practicable, search terms used)

CNTXT, CNABS, CNKI: 电池, 异常, 故障, 采样, 采集, 预处理, 填补, 填充, 去噪, 噪声, 滤除, 剔除, 去除, 平滑, 相邻, 邻近, 临近, 附近, 紧邻, 邻接, 单个, 个别, 单独, 个体, 整体, 整个, 共同, 方差, 均值, 平均, 离群, 散落, 离散, 偏移, 坏, 跳, 偏离, 突变, 跳变, 走势, 趋势, 变化, 标志, 标签, 标记; VEN, USTXT, WOTXT, EPTXT: battery, abnormal, fault, sample, collect, pretreatment, fill, noise, filter, reject, smooth, adjacent, near, single, individual, separate, whole, common, variance, mean, outlier, offset, mutation, trip point, ambulation, trend, label, sign

**C.    DOCUMENTS CONSIDERED TO BE RELEVANT**

| Category* | Citation of document, with indication, where appropriate, of the relevant passages | Relevant to claim No. |
|---|---|---|
| PX | CN 116299019 A (HEFEI GUOXUAN HIGH-TECH POWER ENERGY CO., LTD.) 23 June 2023 (2023-06-23)<br>     claims 1-10 | 1-10 |
| Y | CN 115792634 A (BEIHANG UNIVERSITY) 14 March 2023 (2023-03-14)<br>     description, paragraphs 30-42, and figures 2-3 | 1-6, 8-10 |
| Y | CN 114490156 A (HANGZHOU DIANZI UNIVERSITY) 13 May 2022 (2022-05-13)<br>     description, paragraphs 71-123 | 1-6, 8-10 |
| Y | CN 115238735 A (CHINA GRIDCOM CO., LTD. et al.) 25 October 2022 (2022-10-25)<br>     description, paragraphs 47-95 | 1-6, 8-10 |
| Y | CN 114116742 A (PCI TECHNOLOGY GROUP CO., LTD. et al.) 01 March 2022<br>(2022-03-01)<br>     description, paragraphs 50-58 | 1-6, 8-10 |

☑ Further documents are listed in the continuation of Box C.                ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **10 December 2023** | **13 December 2023** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/110911**

**C.    DOCUMENTS CONSIDERED TO BE RELEVANT**

| Category* | Citation of document, with indication, where appropriate, of the relevant passages | Relevant to claim No. |
|---|---|---|
| A | CN 114742124 A (SHANDONG LURUAN DIGITAL TECHNOLOGY CO., LTD.) 12 July 2022 (2022-07-12)<br>entire document | 1-10 |
| A | CN 114518539 A (BEIJING JIAOTONG UNIVERSITY) 20 May 2022 (2022-05-20)<br>entire document | 1-10 |
| A | CN 114910800 A (CHONGQING CHANG'AN NEW ENERGY AUTOMOBILE TECHNOLOGY CO., LTD.) 16 August 2022 (2022-08-16)<br>entire document | 1-10 |
| A | CN 114594398 A (CHINA THREE GORGES CORP. et al.) 07 June 2022 (2022-06-07)<br>entire document | 1-10 |
| A | CN 108320063 A (SHANGHAI IESLAB ENERGY TECHNOLOGY CO., LTD.) 24 July 2018 (2018-07-24)<br>entire document | 1-10 |
| A | CN 115840923 A (NETIS TECHNOLOGIES CO., LTD.) 24 March 2023 (2023-03-24)<br>entire document | 1-10 |
| A | JP 2009217555 A (MITSUBISHI ELECTRIC CORP.) 24 September 2009 (2009-09-24)<br>entire document | 1-10 |

Form PCT/ISA/210 (second sheet) (July 2022)

**INTERNATIONAL SEARCH REPORT**
Information on patent family members

International application No.

**PCT/CN2023/110911**

| Patent document cited in search report | | | Publication date (day/month/year) | Patent family member(s) | | | Publication date (day/month/year) |
|---|---|---|---|---|---|---|---|
| CN | 116299019 | A | 23 June 2023 | None | | | |
| CN | 115792634 | A | 14 March 2023 | None | | | |
| CN | 114490156 | A | 13 May 2022 | None | | | |
| CN | 115238735 | A | 25 October 2022 | None | | | |
| CN | 114116742 | A | 01 March 2022 | CN | 114116742 | B | 08 August 2023 |
| CN | 114742124 | A | 12 July 2022 | None | | | |
| CN | 114518539 | A | 20 May 2022 | None | | | |
| CN | 114910800 | A | 16 August 2022 | None | | | |
| CN | 114594398 | A | 07 June 2022 | None | | | |
| CN | 108320063 | A | 24 July 2018 | None | | | |
| CN | 115840923 | A | 24 March 2023 | None | | | |
| JP | 2009217555 | A | 24 September 2009 | None | | | |

Form PCT/ISA/210 (patent family annex) (July 2022)